# EUROPEAN PATENT APPLICATION

(11) **EP 1 892 758 A2**
(43) Date of publication of application: **27.02.2008**
(21) Application number: 07016069.2
(22) Date of filing: 16.08.2007
(51) Int. Cl.: H01L 21/77, H01L 29/786

(54) **Manufacturing of flexible display device panel**

(30) Priority: 23.08.2006 KR 20060079911
(71) Applicant: Samsung Electronics Co., Ltd., Yeongtong-gu Suwon-city, Gyeonggi-do 442-742 (KR)
(72) Inventor: Hwang, Tae-Hyung, Yongsan-gu, Seoul (KR); Nikulin, Ivan, Suwon-si, Gyeonggi-do (KR); Jeon, Hyung-II, Nam-gu, Incheon-si (KR); Kim, Sang-II, Yongin-si, Gyeonggi-do (KR); Roh, Nam-Seok, Seongnam-si, Gyeonggi-do (KR)
(74) Representative: Weitzel, Wolfgang

(57) **Abstract**

A manufacturing method of a display panel for an LCD includes forming a gate line on a flexible insulation substrate, depositing a gate insulating layer on the gate line, forming a semiconductor layer on the gate insulating layer and forming a data line and a drain electrode on the semiconductor layer and the gate insulating layer. The forming the semiconductor layer may be performed by PECVD at about 100°C to about 180°C, the gate insulating layer may have a thickness of about 2000Å to about 5500. The method may further include performing hydrogen plasma treatment on the gate insulating layer after the depositing the gate insulating layer and annealing the substrate having the plurality of thin films after the forming the data line and the drain electrode. The insulation substrate may include PES.

## Description

### CROSS-REFERENCE TO RELATED APPLICATION

This application claims priority to and the benefit of Korean Patent Application No. 10-2006-0079911 filed in the Korean Intellectual Property Office on August 23, 2006, the entire contents of which are incorporated herein by reference.

### BACKGROUND OF THE INVENTION

### Field of the invention

The present invention relates to a display panel for a flexible display device and a manufacturing method thereof.

### Description of the Related Art

Liquid crystal and organic light emitting diode (OLED) displays are representative of flat panel displays that are used widely. The liquid crystal display generally includes an upper panel in which a common electrode, color filters, etc., are formed, a lower panel in which thin film transistors (TFTs) and pixel electrodes are formed. A liquid crystal layer is interposed between the two display panels. If a potential difference is applied between a pixel electrode and the common electrode, the resultant electric field in the liquid crystal layer determines the orientation of the liquid crystal molecules and controls the transmittance of incident light through the liquid crystal layer. Accordingly, a desired image can be displayed by adjusting the potential difference between the two electrodes. An OLED display includes a hole injection electrode (anode), an electron injection electrode (cathode) together with an organic emission layer formed therebetween, and emits light through the recombination of the holes and electrons. However, because such a display device uses a heavy and fragile glass substrate, it is not suitable for portable and large scale displays. Accordingly, a display device using a flexible substrate such as a plastic substrate having light weight, impact resistance, and flexibility has been developed.
However, the plastic substrate is easily warped by the high temperature used during the manufacturing process and therefore thin film transistors that may be deposited at a low temperature are used to prevent deformation of the plastic substrate. However, the performance of the TFT formed by low temperature deposition may not as high as desired.

### SUMMARY OF THE INVENTION

A manufacturing method of a display panel for an LCD according to one embodiment of the present invention includes forming a gate line on a flexible insulation substrate, depositing a gate insulating layer on the gate line, forming a semiconductor layer on the gate insulating layer and forming a data line and a drain electrode on the semiconductor layer and the gate insulating layer. The forming the semiconductor layer may be performed by PECVD at about 100°C to about 180°C.

The semiconductor layer may be formed busing PECVD with RF power of about 300W or lower, and preferably with RF power of about 150W to about 300W.

The gate insulating layer may be thinner than about 5500Å and preferably with a thickness of about 2000Å to about 5500Å.

The method may further include performing a hydrogen plasma treatment on the gate insulating layer after the depositing the gate insulating layer.

The hydrogen plasma treatment may be performed by supplying H₂ at a pressure of about 2000Torr and a temperature of about 130°C for about 30 seconds.

The method may include annealing the substrate having the plurality of thin films after forming the data line and the drain electrode.

The annealing may be performed at 150°C for about 1 hour or longer.

The annealing may be performed at 150°C for about 3 hours.

The insulation substrate may include plastic.

The insulation substrate may include PES.

A display panel for an LCD according to an embodiment of the present invention includes a flexible insulation substrate; a gate line formed on the substrate; a gate insulating layer formed on the gate line, having a thickness of about 2000Å to about 5500Å, and subjected to hydrogen plasma treatment; a semiconductor layer formed on the gate insulating layer and deposited by PECVD at about 100°C to 180°C; and a data line including a source electrode, and drain electrode formed on the semiconductor layer and the gate insulating layer.

The semiconductor layer may be deposited by PECVD with RF power of about 300W or lower and preferably with RF power of about 150W to about 300W.

The hydrogen plasma treatment may be performed by supplying H₂ at a pressure of about 2000Torr and a temperature of about 130°C for about 30 seconds.

The display panel may be subjected to annealing at 150°C for about 1 hour or longer and preferably for about 3 hours.

### BRIEF DESCRIPTION OF THE DRAWINGS

The present invention will be described more fully hereinafter with reference to the accompanying drawings, in which:

FIG. 1 is a layout view of a TFT array panel according to an embodiment of the present invention;

FIG. 2 and FIG. 3 are sectional views of the TFT array panel shown in FIG. 1 taken along the lines II-II and III-III, respectively;

FIG. 4, FIG. 7, FIG. 11, and FIG. 14 are layout views of the TFT array panel in an intermediate step of a manufacturing method thereof according to an embodiment of the present invention;

FIG. 5 and FIG. 6 are sectional views of the TFT array panel shown in FIG. 4 taken along the lines V-V and VI-VI, respectively;

FIG. 8 and FIG. 9 are sectional views of the TFT array panel shown in FIG. 7 taken along the lines VIII-VIII and IX-IX, respectively;

FIG. 10A to FIG. 10C are sectional views sequentially showing a manufacturing method of the TFT array panel shown in FIG. 7 to FIG. 9;

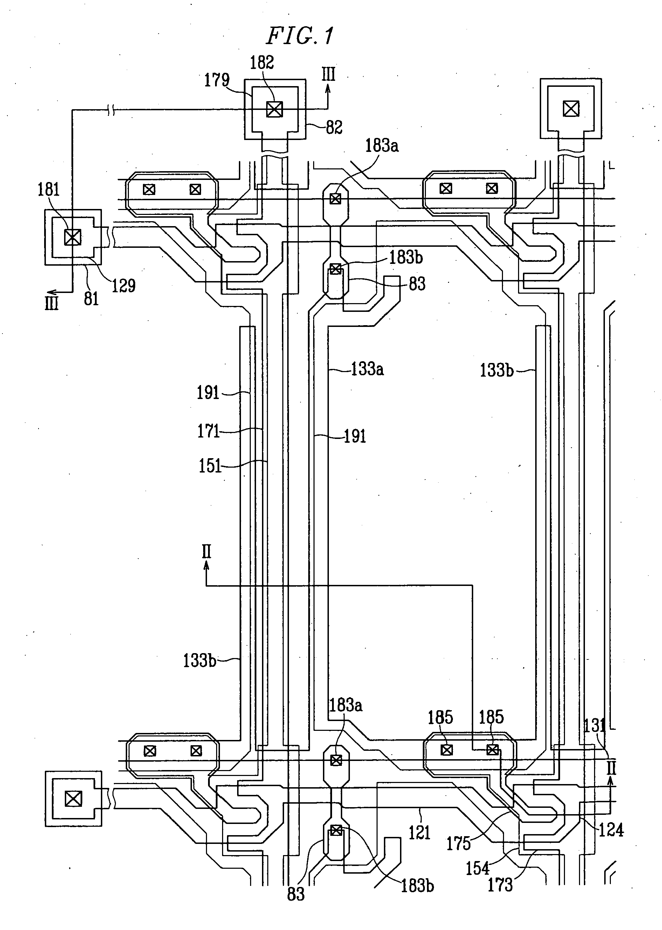

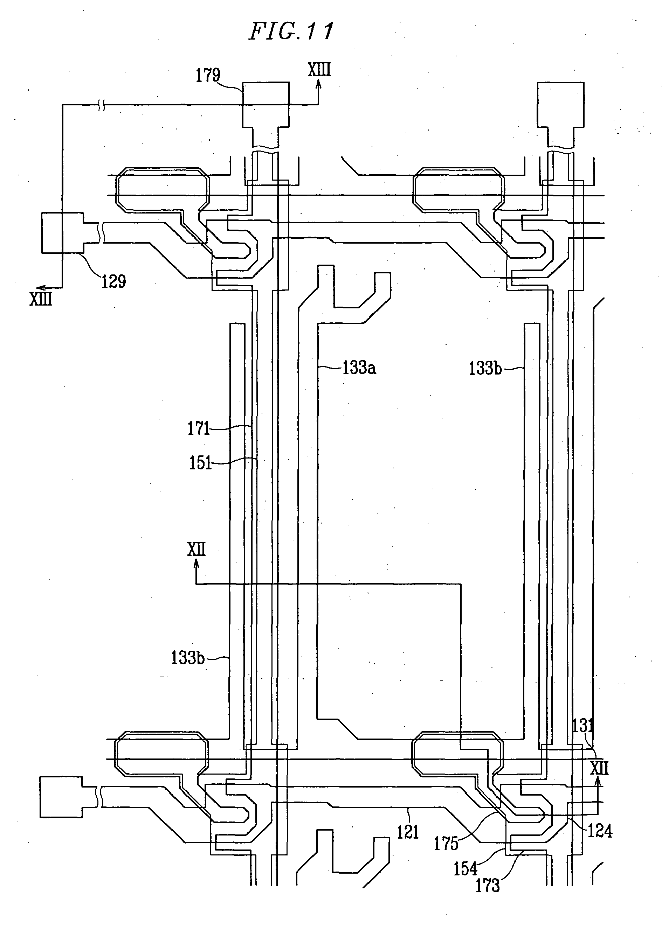

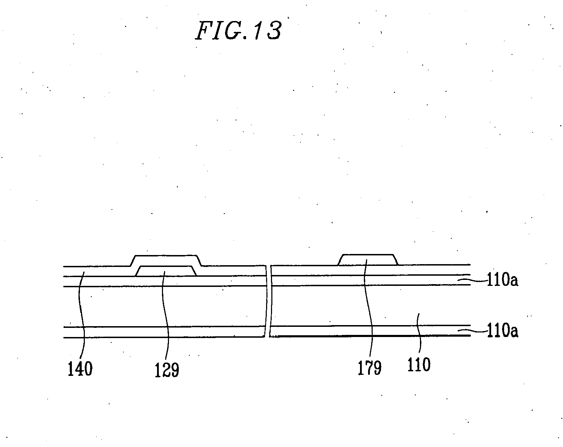

FIG. 1 2 and FIG. 13 are sectional views of the TFT array panel shown in FIG. 11 taken along the lines XII-XII and XIII-XIII, respectively; and

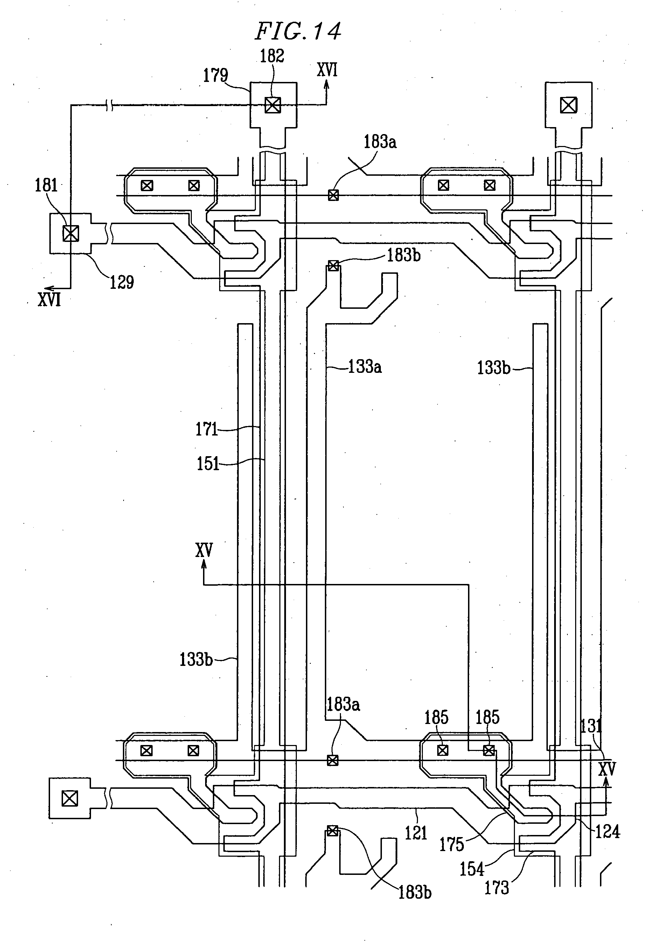

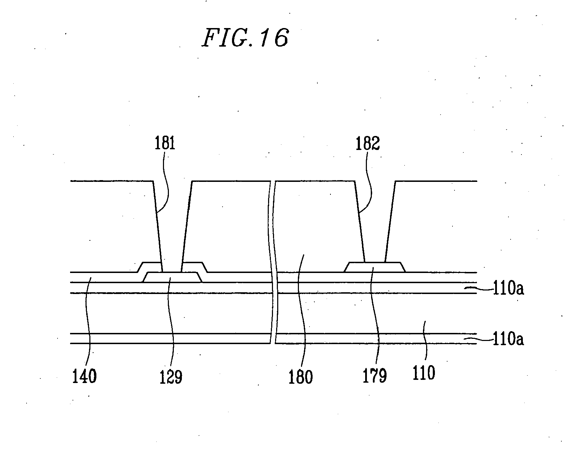

FIG. 1 5 and FIG. 16 are sectional views of the TFT array panel shown in FIG. 14 taken along the lines XV-XV and XVI-XVI, respectively.

### DETAILED DESCRIPTION OF THE EMBODIMENTS

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

First, a thin film transistor (TFT) array panel according to an embodiment of the present invention will be described in detail with reference to FIG. 1 to FIG. 3.

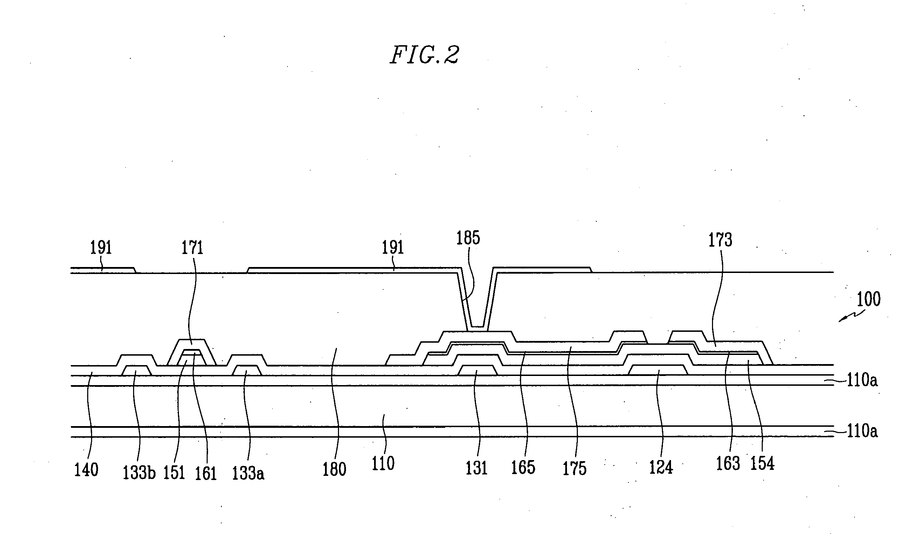

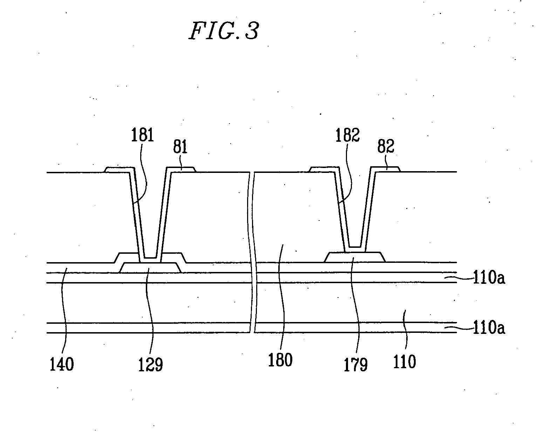

FIG. 1 is a layout view of a TFT array panel according to an embodiment of the present invention, and FIG. 2 and FIG. 3 are sectional views of the TFT array panel shown in FIG. 1 taken along the lines II-II and III-III, respectively.

A plurality of gate lines 121 and a plurality of storage electrode lines 1 31 are formed on a flexible insulating substrate 110.

The substrate 110 may include transparent plastic, etc. Also, the substrate 110 may include polyethersulphone (PES).

Barrier layers 110a are disposed on both surfaces of the substrate 110, respectively. The barrier layers 110a prevent oxygen or moisture from penetrating the substrate 110 . The barrier layers 110a may be made of silicon oxide (SiOx) or silicon nitride (SiNx) . At least one of the barrier layers 110a may be omitted.

The gate lines 121 transmit gate signals and extend substantially in a transverse direction. Each of the gate lines 121 includes a plurality of gate electrodes 124 projecting downward and an end portion 1 29 having a large area for contact with another layer or an external driving circuit. A gate driving circuit (not shown) for generating the gate signals may be mounted on a flexible printed circuit (FPC) film (not shown), which may be attached to the substrate 110, directly mounted on the substrate 110, or integrated with the substrate 110 . The gate lines 121 may extend to be connected to a driving circuit that may be integrated with the substrate 110.

The storage electrode lines 131 are supplied with a predetermined voltage, and each of the storage electrode lines 131 includes a stem extending substantially parallel to the gate lines 121 and a plurality of pairs of first and second storage electrodes 133a and 133b branching from the stem. Each of the storage electrode lines 131 is disposed between two adjacent gate lines 121, and the stem is close to one of the two adjacent gate lines 121. Each of the storage electrodes 133a and 133b has a fixed end portion connected to the stem and a free end portion disposed opposite thereto. The fixed end portion of the first storage electrode 133a has a large area and the free end portion thereof is bifurcated into a linear branch and a curved branch. However, the storage electrode lines 131 may have various shapes and arrangements.

The gate lines 121 and the storage electrode lines 131 may be made of an Al-containing metal such as Al and an Al alloy, a Ag-containing metal such as Ag and a Ag alloy, a Cu-containing metal such as Cu and a Cu alloy, a Mo-containing metal such as Mo and a Mo alloy, Cr, Ta, or Ti. However, they may have a multi-layered structure including two conductive films (not shown) having different physical characteristics. One of the two films may be made of a low resistivity metal including an Al-containing metal, an Ag-containing metal, and a Cu-containing metal for reducing signal delay or voltage drop. The other film may be made of a material, such as a Mo-containing metal, Cr, Ta, or Ti, which has good physical, chemical, and electrical contact characteristics with other materials such as indium tin oxide (ITO) or indium zinc oxide (IZO). Good examples of the combination of the two films are a lower Cr film and an upper Al (alloy) film, and a lower Al (alloy) film and an upper Mo (alloy) film. However, the gate lines 121 and the storage electrode lines 131 may be made of various metals or conductors.

The lateral sides of the gate lines 121 and the storage electrode lines 131 are inclined relative to a surface of the substrate 110, and the inclination angle thereof ranges from about 30 degrees to about 80 degrees.

A gate insulating layer 140 made of silicon nitride (SiNx) or silicon oxide (SiOx) is formed on the gate lines 121 and the storage electrode lines 131. The thickness of the gate insulating layer 140 may be thinner than about 5500Å, and preferably may be about 2000Å to about 5500Å.

A plurality of semiconductor stripes 151, which may be made of hydrogenated amorphous silicon (abbreviated to "a-Si") or polysilicon, are formed on the gate insulating layer 140. Each semiconductor stripe 151 extends substantially in the longitudinal direction and includes a plurality of projections 154 branched out toward the gate electrodes 124. The semiconductor stripes 151 become wide near the gate lines 121 and the storage electrode lines 131 such that the semiconductor stripes 151 cover large areas of the gate lines 121 and the storage electrode lines 131.

A plurality of ohmic contact stripes and islands 161 and 165 are formed on the semiconductor stripes 151. The ohmic contacts 161 and 1 65 are preferably made of n+ hydrogenated a-Si heavily doped with an n-type impurity such as phosphorous, or they may be made of silicide. Each of the ohmic contact stripes 161 includes a plurality of projections 163, and the projections 163 and the ohmic contact islands 165 are located in pairs on the projections 154 of the semiconductor stripes 151.

The semiconductors 151, and the ohmic contacts 161 and 165 may be deposited by plasma enhanced chemical vapor deposition (PECVD) at a temperature of about 100°C to about 180°C, and a radio frequency (RF) power of about 300W or lower, for example, about 150W to about 300W.

The lateral sides of the semiconductor stripes 151 and the ohmic contacts 161 and 165 are inclined relative to the surface of the substrate 110, and the inclination angles thereof are preferably in a range of about 30 to 80 degrees. .

A plurality of data lines 171 and a plurality of drain electrodes 175 are formed on the ohmic contacts 161 and 165 and the gate insulating layer 140.

The data lines 171 transmit data signals and extend substantially in the longitudinal direction to intersect the gate lines 121. Each of the data lines 171 also intersects the storage electrode lines 131 and runs between adjacent pairs of storage electrodes 133a and 133b. Each data line 171 includes a plurality of source electrodes 173 projecting toward the gate electrodes 124 and curved like a character and an end portion 179 for contact with another layer or an external driving circuit. A data driving circuit (not shown) for generating the data signals may be mounted on an FPC film (not shown), which may be attached to the substrate 110, directly mounted on the substrate 110, or integrated onto the substrate 110. The data lines 171 may extend to be connected to a driving circuit that may be integrated on the substrate 110.

The drain electrodes 175 are separated from the data lines 171 and disposed opposite the source electrodes 173 with respect to the gate electrodes 124. Each of the drain electrodes 175 includes a wide end portion and a narrow end portion. The wide end portion overlaps a storage electrode line 1 31, and the narrow end portion is partly enclosed by a source electrode 173.

A gate electrode 124, a source electrode 173, and a drain electrode 1 75 along with a projection 1 54 of a semiconductor stripe 1 51 form a TFT having a channel formed in the projection 1 54 disposed between the source electrode 173 and the drain electrode 175.

The data lines 171 and the drain electrodes 175, may be made of refractory metal such as Mo, Cr, Ta, Ti, or alloys thereof. However, they may have a multilayered structure including a refractory metal film (not shown) and a low resistivity film (not shown). Good examples of the multi-layered structure are a double-layered structure including a lower Cr/Mo (alloy) film and an upper Al (alloy) film, and a triple-layered structure of a lower Mo (alloy) film, an intermediate Al (alloy) film, and an upper Mo (alloy) film. However, the data lines 171 and the drain electrodes 175 may be made of various metals or conductors.

The data lines 171 and the drain electrodes 175 have inclined edge profiles, and the inclination angles thereof range from about 30 degrees to about 80 degrees.

The ohmic contacts 161 and 165 are interposed only between the underlying semiconductors 151 and the overlying conductors 1 71 and 1 75 thereon, and reduce the contact resistance therebetween. Although the semiconductor stripes 151 are narrower than the data lines 171 at most places, the width of the semiconductor stripes 1 51 becomes large near the gate lines 1 21 and the storage electrode lines 131 as described above, to smooth the profile of the surface, thereby preventing disconnection of the data lines 171. However, the semiconductor stripes 151 include some exposed portions, which are not covered with the data lines 1 71 and the drain electrodes 175, such as portions located between the source electrodes 1 73 and the drain electrodes 175.

A passivation layer 180 is formed on the data lines 171, the drain electrodes 1 75, and the exposed portions of the semiconductor stripes 151.
The passivation layer 180 may be made of an inorganic insulator or an organic insulator, and it may have a flat top surface. Examples of the inorganic insulator include silicon nitride and silicon oxide. The organic insulator may have photosensitivity and a dielectric constant less than about 4.0. The passivation layer 180 may include a lower film of an inorganic insulator and an upper film of an organic insulator, such that it takes the excellent insulating characteristics of the organic insulator while preventing the exposed portions of the semiconductor stripes 151 from being damaged by the organic insulator.

The passivation layer 180 has a plurality of contact holes 182 and 185 exposing the end portions 179 of the data lines 171 and the drain electrodes 175, respectively. The passivation layer 180 and the gate insulating layer 140 have a plurality of contact holes 181 exposing the end portions 129 of the gate lines 121, a plurality of contact holes 183a exposing portions of the storage electrode lines 131 near the fixed end portions of the first storage electrodes 133a, and a plurality of contact holes 183b exposing the linear branches of the free end portions of the first storage electrodes 133a.

A plurality of pixel electrodes 191, a plurality of overpasses 83, and a plurality of contact assistants 81 and 82 are formed on the passivation layer 180. They may be made of a transparent conductor such as ITO or IZO, or a reflective conductor such as Ag, Al, Cr or alloys thereof.

The pixel electrodes 191 are physically and electrically connected to the drain electrodes 1 75 through the contact holes 185 such that the pixel electrodes 191 receive data voltages from the drain electrodes 175. The pixel electrodes 191 supplied with the data voltages generate electric fields in cooperation with a common electrode (not shown) of an opposing display panel (not shown) supplied with a common voltage, which determine the orientation of liquid crystal molecules (not shown) of a liquid crystal layer (not shown) disposed between the two electrodes to determine the polarization of light passing through the liquid crystal layer.

A pixel electrode 191 and the common electrode form a capacitor referred to as a "liquid crystal capacitor" that stores applied voltages after the TFT turns off.

A pixel electrode 191 and a drain electrode 1 75 connected thereto overlap a storage electrode line 131 including storage electrodes 133a and 133b. The pixel electrode 191, a drain electrode 175 connected thereto, and the storage electrode line 1 31 form an additional capacitor referred to as a "storage capacitor," which enhances the voltage storing capacity of the liquid crystal capacitor.

The contact assistants 81 and 82 are connected to the end portions 129 of the gate lines 121 and end portions of the data lines 171 through the contact holes 181 and 182, respectively. The contact assistants 81 and 82 protect the end portions 129 and 1 79 and enhance the adhesion between the end portions 129 and 179 and external devices.

The overpasses 83 cross over the gate lines 121 and are connected to the exposed portions of the storage electrode lines 131 and the exposed linear branches of the free end portions of the storage electrodes 133b through the contact holes 183a and 183b, respectively, which are disposed opposite each other with respect to the gate lines 121. The storage electrode lines 131 including the storage electrodes 133a and 1 33b along with the overpasses 83 can be used for repairing defects in the gate lines 121, the data lines 171, or the TFTs.

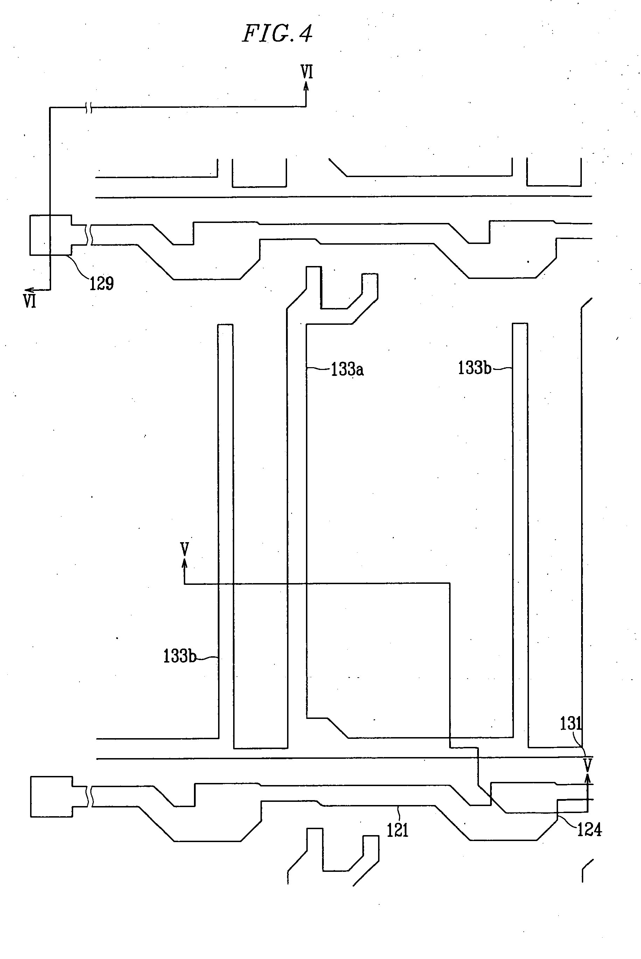

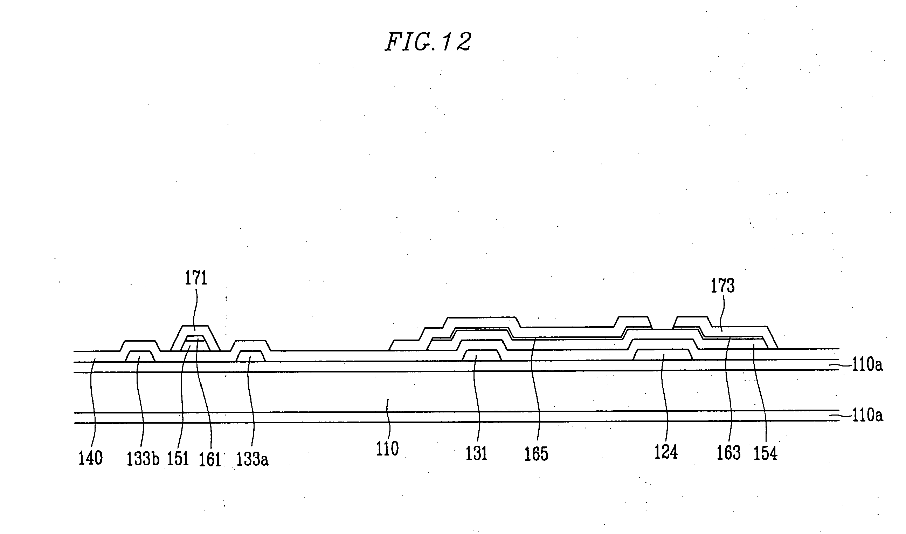

Now, a manufacturing method of the TFT array panel shown in FIG. 1 to FIG. 3 according to an embodiment of the present invention will be described in detail with reference to FIG. 4 to FIG. 16 along with FIG. 1 to FIG. 3.

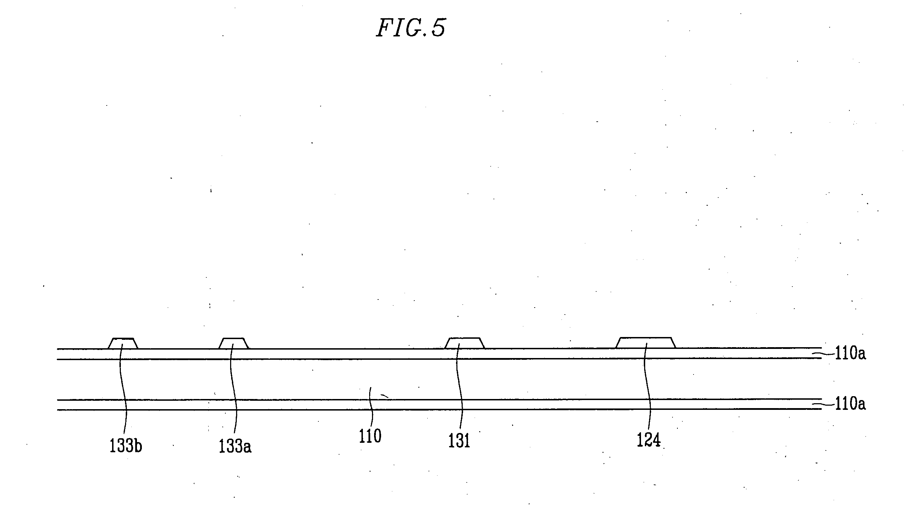

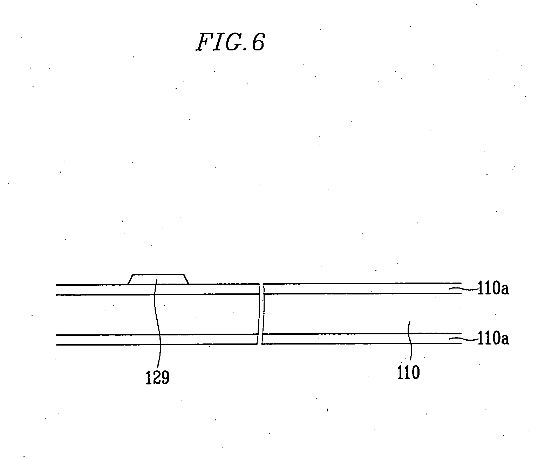

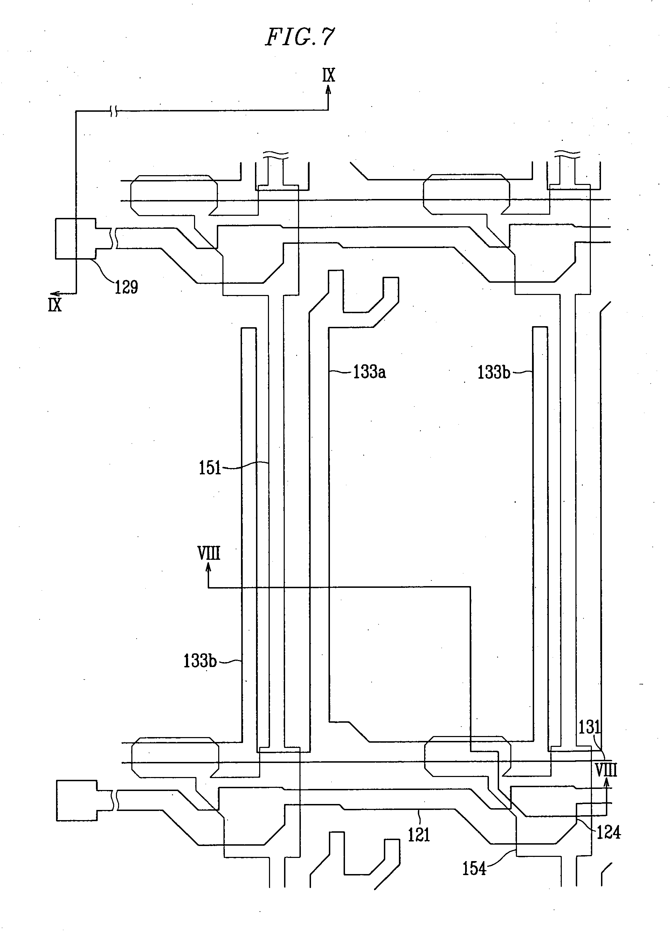

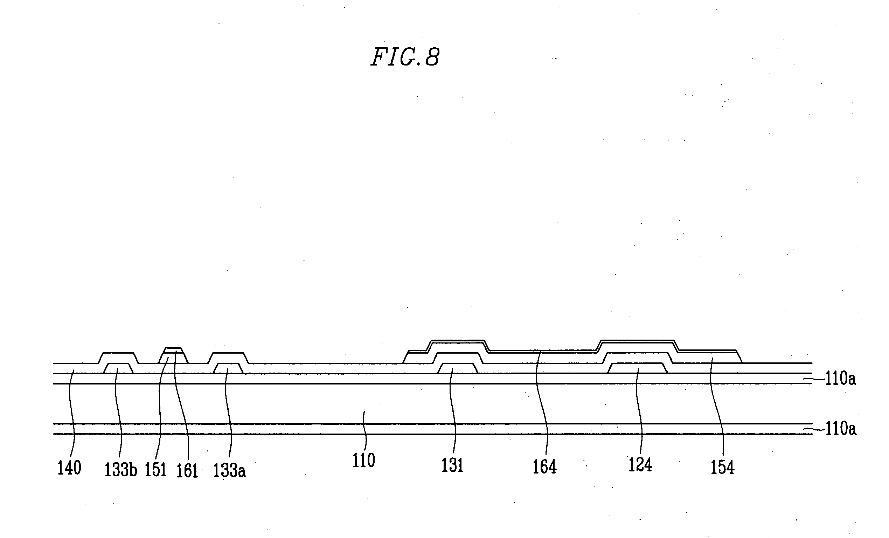

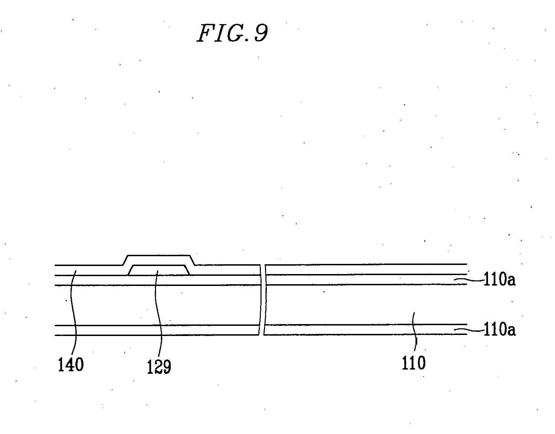

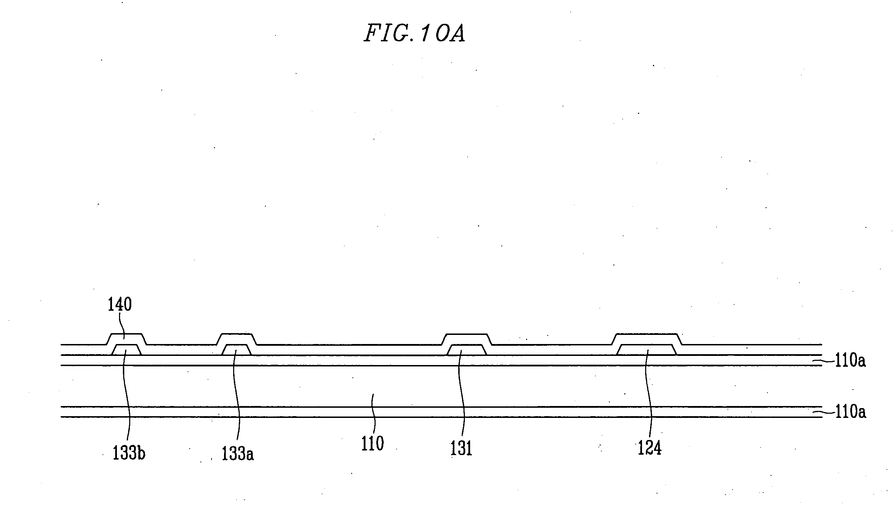

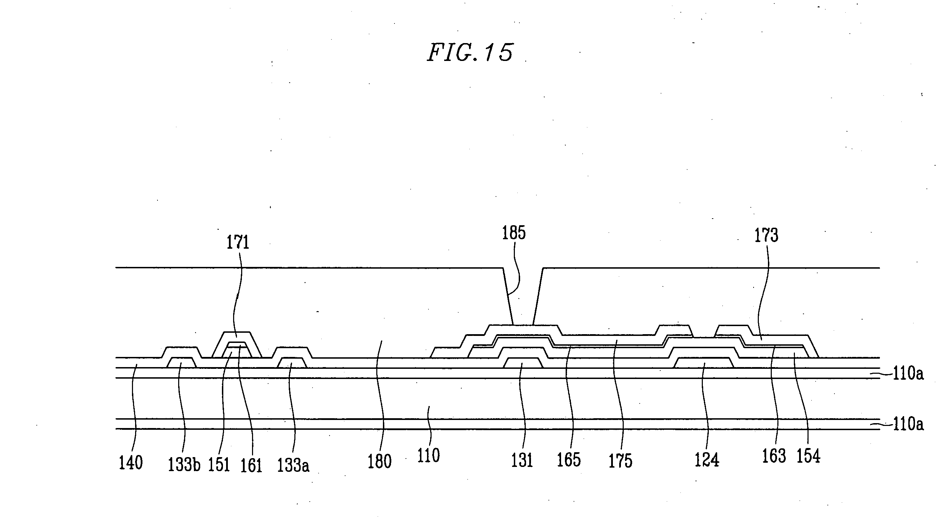

FIG. 4, FIG. 7, FIG. 11, and FIG. 14 are layout views of the TFT array panel in an intermediate step of a manufacturing method thereof according to an embodiment of the present invention. FIG. 5 and FIG. 6 are sectional views of the TFT array panel shown in FIG. 4 taken along the lines V-V and VI-VI, respectively, FIG. 8 and FIG. 9 are sectional views of the TFT array panel shown in FIG. 7 taken along the lines VIII-VIII and IX-IX, respectively, FIG. 10A to FIG. 10C are sectional views sequentially showing a manufacturing method of the TFT array panel shown in FIG. 7 to FIG. 9, FIG. 12 and FIG. 13 are sectional views of the TFT array panel shown in FIG. 1 1 taken along the lines XII-XII and XIII-XIII, respectively, and FIG. 15 and FIG. 16 are sectional views of the TFT array panel shown in FIG. 14 taken along the lines XV-XV and XVI-XVI, respectively.

Referring to FIG. 4 to FIG. 6, a metal layer is deposited on an insulation substrate 110 covered with barrier layers 110a and patterned by photolithography and etching to form a plurality of gate lines 121 including a plurality of gate electrodes 124 and end portions 129, and a plurality of storage electrode lines 131 including a plurality of storage electrodes 1 33a and 133b. Here, the substrate 110 may include plastic. Also, the substrate 110 may include PES with no birefringence, and with high transmittance, high heat resistance, and high chemical resistance.

Next, a gate insulating layer 140 is deposited on the substrate 110, and then a plurality of intrinsic semiconductor stripes 1 51 including a plurality of projections 154 and a plurality of extrinsic semiconductor stripes 164 are formed on the gate electrodes 124 as shown in FIG. 7 to FIG. 9.

Now, the formation of the gate insulating layer 140, the intrinsic semiconductor stripes 151, and the extrinsic semiconductor stripes 164 will be described in more detail with reference to FIG. 10A to FIG. 10C.

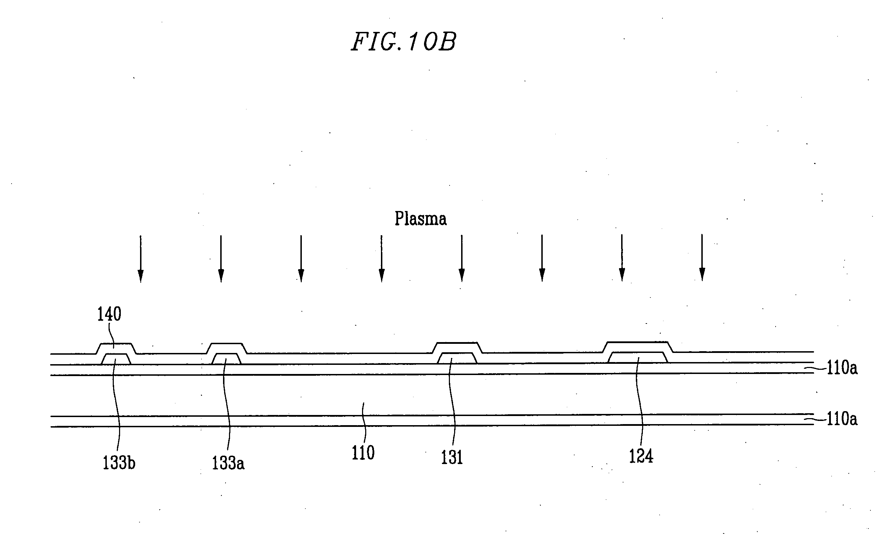

Referring to FIG. 10A, the gate insulating layer 140 made of SiNx is deposited by plasma enhanced chemical vapor deposition (PECVD), etc. Here, the gate insulating layer 140 may have a thickness of about 5500Å or thinner, and particularly about 2000Å to about 5500Å. Thereafter, the gate insulating layer 140 is subjected to hydrogen plasma treatment by supplying hydrogen gas (H₂) at a pressure of about 2000Torr and a temperature of about 130°C for about 30 seconds, as shown in FIG. 10B. The hydrogen plasma treatment may enhance contact characteristics between the gate insulating layer 140 and overlying thin film.

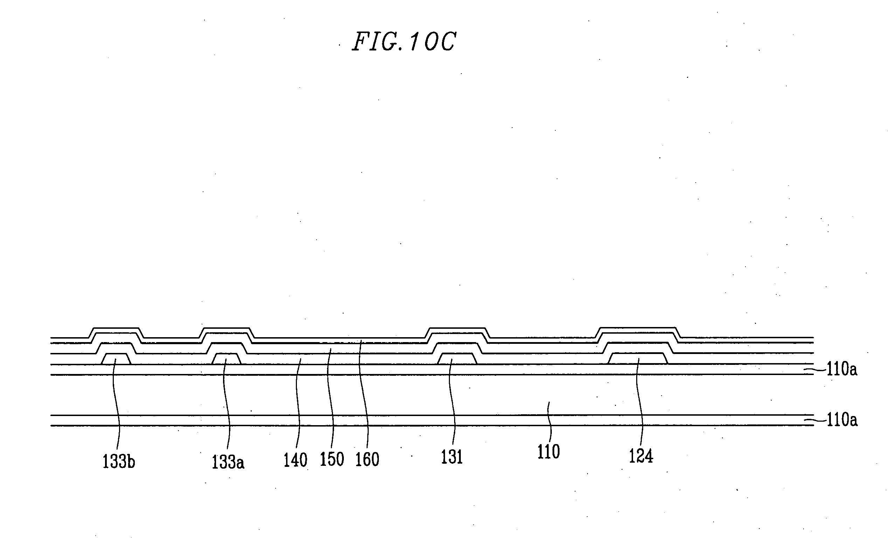

Thereafter, an intrinsic a-Si layer 1 50 and an extrinsic a-Si layer 160 are sequentially deposited on the hydrogen plasma treated gate insulating layer 140 as shown in FIG. 10C. Here, the intrinsic a-Si layer 150 and the extrinsic a-Si layer 160 may be deposited by PECVD, etc., at a temperature of about 100°C to about 180°C, and a radio frequency (RF) power of about 300W or lower, for example about 150W to about 300W.

And then, the intrinsic a-Si layer 1 50 and the extrinsic a-Si layer 160 are patterned by photolithography and etching to form a plurality of intrinsic semiconductor stripes 151 and a plurality of extrinsic semiconductor stripes 164.

Referring to FIG. 11 to FIG. 13, a metal layer is deposited and patterned by photolithography and etching to form a plurality of data lines 171 including a plurality of source electrodes 173 and end portions 179, and a plurality of drain electrodes 175. Thereafter, exposed portions of the extrinsic semiconductor stripes 164, which are not covered with the data lines 1 71 and the drain electrodes 175, are removed to complete a plurality of ohmic contact stripes 161 including projections 163 and a plurality of ohmic contact islands 165 and to expose portions of the intrinsic semiconductor stripes 151.

Next, a passivation layer 180 is deposited and patterned by photolithography (and etching) along with the gate insulating layer 140 to form a plurality of contact holes 181, 182, 183a, 183b, and 185, as shown in FIG. 14 to FIG. 16.

A transparent conductive layer such as ITO or IZO is deposited by sputtering, etc., and then is patterned by photolithography and etching to form a plurality of pixel electrodes 191, a plurality of contact assistants 81 and 82, and a plurality of overpasses 83 on the passivation layer 180 as shown in FIG. 1 to FIG. 3.

Finally, the substrate 110 having the thin films described above is subjected to annealing at about 150°C and for about 1hour or longer, particularly for about 3hours or longer. The annealing may make the semiconductors 151 stable.

Now, a performance characteristic variation of a TFT according to experimental examples according to the present invention will be described.

In an Experimental Example, for measuring the effects of thickness of the gate insulating layer on the performance characteristic of the TFT, gate insulating layers having a thickness of about 4000Å, about 4500Å, about 5000Å, and about 5500Å were formed in TFTs, respectively, and then the performance of the TFTs was measured. Here, conditions were the same except for the thickness of the gate insulating layers. The results according to the experiment are shown in Table 1.

**Table 1**

| Thickness of gate insulating layer (Å) | Performance characteristic of TFT | | | | |
|---|---|---|---|---|---|
| | Mobility (cm²/Vₛ) | On-current(Iₒₙ) (µA) | Off-current(I_{off}) (pA) | Threshold voltage(Vₛ) (V) | Iₒₙ/I_{off} x 10⁶ |
| 5500 | 0.06 | 0.10 | 0.2 | 11.1 | 0.5 |
| 5000 | 0.075 | 0.18 | 0.1 | 10.6 | 1.8 |
| 4500 | 0.07 | 0.20 | 0.1 | 10.4 | 2.0 |
| 4000 | 0.09 | 0.30 | 0.1 | 10.2 | 3.0 |

Referring to Table 1, the current characteristics of the TFTs including gate insulating layers of about 5500Å and thinner satisfy desirable current characteristics of a TFT for an LCD. Also, the thinner the gate insulating layer was, the larger the ratio of on-current and off-current (Iₒₙ/I_{off}) became. However, if the gate insulating layer is thinner than about 2000Å, the gate insulating layer may not insulate the gate electrode from the overlying film.

Accordingly, the TFT array panel according to an embodiment of the present invention may have TFTs including a gate insulating layer of about 2000Å to about 5500Å such that the performance characteristic of TFTs is preserved and the insulating characteristic of the gate insulating layer may be not deteriorated.

In another Experimental Example, for measuring the effects of deposition temperature of the semiconductor layers on the performance characteristic of the TFT, a-Si layers for TFTs were deposited by PECVD at a pressure of about 1500Torr and RF power of about 200W at about 100°C, about 130°C, about 150°C, and about 180°C, respectively, and the a-Si layers were subjected to annealing at about 150°C for about 1hour. Then, the performance of the TFTs was measured. Here, conditions were the same except for the thickness of deposition temperature. The results according to the experiment are shown in Table 2.

**Table 2**

| Deposition temperature (°C) | Performance characteristic of TFT | | | | |
|---|---|---|---|---|---|
| | Mobility. cm²/Vₛ) | On-current(Iₒₙ) (µA) | Off-current(I_{off}) (µA) | Threshold voltage(Vₛ) (V) | Iₒₙ/I_{off} x 10⁶ |
| 100 | 0.2 | 0.33 | 0.3 | 9.7 | 1.0 |
| 130 | 0.81 | 1.67 | 0.068 | 7.8 | 24.6 |
| 150 | 0.46 | 2.34 | 0.006 | 5.81 | 390 |
| 180 | 0.54 | 3.02 | 0.005 | 5.1 | 604 |

Referring to Table 2, the TFTs including semiconductor films deposited at about 100°C to about 1 80°C have a larger ratio of on-current and off-current (Iₒₙ/I_{off}) than desired current characteristics of a TFT for an LCD. Particularly, the TFTs including semiconductor films deposited at a lower temperature of about 100°C to about 130°C than the known deposition temperature and subjected to the annealing also satisfy desirable current characteristics of a TFT for an LCD.

In another Experimental Example, for measuring the effects of deposition RF power of the semiconductor layers on the performance characteristic of the TFT, a-Si layers for TFTs were deposited by PECVD at a pressure of about 1 500Torr, a temperature of about 100°C, and RF power of about 150, about 200, about 300, about 400, and about 500, respectively, and the a-Si layers were subjected to annealing at about 150°C for about 3hours. Then, the performance of the TFTs was measured. Here, conditions were the same except for RF power. The results according to the experiment are shown in Table 2.

**Table 3**

| RF power (W) | Performance characteristic of TFT | | | | |
|---|---|---|---|---|---|
| | Mobility (cm²/Vₛ) | On-current(Iₒₙ) (µA) | Off-current(I_{off}) (pA) | Threshold voltage(Vₛ) (V) | Iₒₙ/I_{off} x 10⁶ |
| 150 | 0.48 | 1.2 | 0.1 | 6.8 | 10 |
| 200 | 0.32 | 0.7 | 0.1 | 8.3 | 7 |
| 300 | 0.19 | 0.28 | 0.2 | 10.5 | 1 |
| 400 | 0.15 | 0.20 | 0.3 | 11.1 | 0.6 |
| 500 | 0.1 | 0.11 | 0.2 | 11.9 | 0.7 |

Referring to Table 3, the current characteristics of the TFTs including semiconductor layers deposited with RF power of about 150W to about 300W have a larger ratio of on-current and off-current (Iₒₙ/I_{off}) than desired current characteristics of a TFT for an LCD. However, the current characteristics of the TFTs including semiconductor layers deposited with RF power of about 400W or about 500W have a smaller ratio of on-current and off-current (Iₒₙ/I_{off}) than desirable current characteristics of a TFT for an LCD.

Accordingly, if the semiconductor layers of TFTs is deposited by PECVD with RF power of about 150W to about 300W according to an embodiment of the present invention, the TFTs have a good performance characteristic even though the semiconductor layers of TFTs are deposited at a lower temperature of about 100°C than the known deposition temperature.

In another Experimental Example, for measuring the effects of annealing of the semiconductor layers on the performance characteristic of the TFT, the TFTs were formed on substrates then the substrates were subjected to annealing at about 150°C, for about 1 hour and 3 hours, respectively, and one substrate was not subjected to annealing. Then, the performance of the TFTs was measured. Here, conditions were the same except for annealing. The results according to the experiment are shown in Table 4.

**Table 4**

| Annealing time (hours) | Performance characteristic of TFT | | | | |
|---|---|---|---|---|---|
| | Mobility (cm²/Vₛ) | On-current(Iₒₙ) (µA) | Off-current(I_{off}) (pA) | Threshold voltage(Vₛ) (V) | Iₒₙ/I_{off} x 10⁶ |
| 0 | 0.02 | 0.02 | 0.3 | 12.3 | 0.05 |
| 1 | 0.2 | 0.33 | 0.3 | 9.7 | 1 |
| 3 | 0.2 | 0.5 | 0.1 | 7.3 | 5 |

Referring to Table 4, the TFT subjected to annealing has better performance than the TFT without annealing. Also, the current characteristics of the TFTs subjected to annealing have almost the same or a larger ratio of on-current and off-current (Iₒₙ/I_{off}) as desired current characteristics of a TFT for an LCD. Particularly, on-current is also increased as well as the ratio of on-current and off-current in the TFT subjected to annealing for 3 hours.

Accordingly, the TFTs performance of the TFT array panel according to an embodiment of the invention may be maintained and enhanced even though the TFT array panel was formed at a lower temperature than the known deposition temperature to prevent deformation of the plastic substrate due to the high temperature.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A manufacturing method of a display panel for an LCD, comprising:
forming a gate line on a flexible insulation substrate;
depositing a gate insulating layer on the gate line;
forming a semiconductor layer on the gate insulating layer; and
forming a data line and a drain electrode on the semiconductor layer and the gate insulating layer, wherein the forming the semiconductor layer is performed by PECVD at about 100°C to about 180°C.

2. The method of claim 1, wherein the forming the semiconductor layer is performed by PECVD with RF power of about 300W or lower.

3. The method of claim 2, wherein the forming the semiconductor layer is performed by PECVD with RF power of about 1 50W to about 300W.

4. The method of claim 1, wherein the gate insulating layer is thinner than about 5500Å.

5. The method of claim 4, wherein the gate insulating layer has a thickness of about 2000Å to about 5500Å.

6. The method of claim 1, further comprising performing hydrogen plasma treatment on the gate insulating layer after the depositing the gate insulating layer.

7. The method of claim 6, wherein the hydrogen plasma treatment is performed by supplying H₂ at a pressure of about 2,000 Torr and a temperature of about 130°C for about 30 seconds.

8. The method of claim 1, further comprising
annealing the substrate having the plurality of thin films after the forming the data line and the drain electrode.

9. The method of claim 8, wherein the annealing is performed at 150°C for about 1 hour or longer.

10. The method of claim 9, wherein the annealing is performed at 150°C for about 3 hours.

11. The method of claim 1, wherein the insulation substrate includes plastic.

12. The method of claim 1, wherein the insulation substrate includes PES.

13. A display panel for an LCD, comprising:
a flexible insulation substrate;
a gate line formed on the substrate;
a gate insulating layer formed on the gate line, having a thickness of about 2000Å to about 5500Å, and subjected to hydrogen plasma treatment; a semiconductor layer formed on the gate insulating layer and deposited by PECVD at about 100°C to 180°C; and
a data line including a source electrode, and drain electrode formed on the semiconductor layer and the gate insulating layer.

14. The display panel of claim 13, wherein the semiconductor layer is deposited by PECVD with RF power of about 300W or lower.

15. The display panel of claim 14, wherein the semiconductor layer is deposited by PECVD with RF power of about 150W to about 300W.

16. The display panel of claim 13, wherein the hydrogen plasma treatment is performed by supplying H₂ at a pressure of about 2000Torr and a temperature of about 130°C for about 30 seconds.

17. The display panel of claim 13, wherein the display panel is subjected to annealing at 1 50°C for about 1 hour or longer.

18. The display panel of claim 17, wherein the display panel is subjected to annealing at 150°C for about 3 hours.

19. The display panel of claim 13, wherein the insulation substrate includes plastic.

20. The display panel of claim 13, wherein the insulation substrate includes PES.
